**Europäisches Patentamt**

**European Patent Office**

**Office européen des brevets**

(19)

(11) Veröffentlichungsnummer: **0 461 395 A2**

(12) **EUROPÄISCHE PATENTANMELDUNG**

(21) Anmeldenummer: **91107589.3**

(51) Int. Cl.⁵: **G01R 31/302**

(22) Anmeldetag: **10.05.91**

(30) Priorität: **15.06.90 DE 4019226**

(43) Veröffentlichungstag der Anmeldung:
**18.12.91 Patentblatt 91/51**

(84) Benannte Vertragsstaaten:
**AT BE CH DE FR GB IT LI**

(71) Anmelder: **GRUNDIG E.M.V.**
**Elektro-Mechanische Versuchsanstalt Max**
**Grundig holländ. Stiftung & Co. KG.**
**Kurgartenstrasse 37**
**W-8510 Fürth/Bay.(DE)**

(72) Erfinder: **Eckert, Werner, Grundig E.M.V., Max**
**Grundig**
**holländ, Stiftung & Co KG, Kurgartenstrasse**
**37**
**W-8510 Fuerth(DE)**

(74) Vertreter: **Dreykorn-Lindner, Werner, Dipl.-Ing.**
**GRUNDIG E.M.V. Elektro-Mechanische**
**Versuchsanstalt Max Grundig**
**holländ.Stiftung & Co. KG Lizenz- und**
**Patentabteilung Kurgartenstrasse 37**
**W-8510 Fürth/Bayern(DE)**

(54) **Vorrichtung zur Beleuchtung von Leiterplatten in Leiterplattenprüfeinrichtungen.**

(57) Bei Leiterplattenprüfvorrichtungen werden mit einer Fernsehkamera mehrere Bilder der zu prüfenden Leiterplatte aufgenommen, wobei bei jedem Bild die Lichteinfalls verändert wird, so daß mehrere Bilder der selben Leiterplatte entstehen, die verschiedene Schattenbereiche aufweisen, die durch die auf der Leiterplatte aufgebrachten Bauelemente verursacht werden. Aus der Größe, der Lage und der Form der Schatten kann auf die Größe und Lage der Bauelemente geschlossen werden.

Für eine derartige Prüfeinrichtung ist es nötig, eine Beleuchtungseinrichtung anzugeben, mit der das Prüfobjekt aus verschiedenen Richtungen beleuchtet werden kann, wobei eine weitgehend verschleißfreie Anordnung notwendig ist.

Dies wird erfindungsgemäß dadurch erreicht, daß das Licht einer Lichtquelle direkt in merere Lichtleiter eingespeist wird, wobei diese Lichtleiter Lichtventile enthalten, die durch elektrische Steuersignale in einen lichtdurchlässigen, bzw. lichtundurchlässigen Zustand geschaltet werden können, so daß die Beleuchtung der Leiterplatte durch einen oder mehrere ausgewählte Lichtleiter erfolgt.

Figur 2

EP 0 461 395 A2

Die Erfindung betrifft eine Vorrichtung zur Beleuchtung von Prüfobjekten in automatischen Prüfoder Kontrolleinrichtungen mit einer Bildverarbeitungseinheit.

Bei automatischen Kontrolleinrichtungen, wie sie beispielsweise bei der automatischen Bestückung von Leiterplatten eingesetzt werden, wird mit einer Bildverarbeitungseinheit überprüft, ob die Leiterplatte mit allen Bauelementen bestückt ist, und ob diese Bauteile in der richtigen Position und Ausrichtung eingesetzt sind.

Zu diesem Zweck wird die Prüffläche bzw. das Prüfobjekt mit einer Fernsehkamera aufgenommen, und mit einem Referenzbild bzw. mit charakteristischen Referenzwerten in einer Bildverarbeitungseinheit verglichen und ausgewertet.

Zur Steigerung der Auswertesicherheit wird das Prüfobjekt von ein oder mehreren Lichtquellen beleuchtet. Eine vorteilhafte Möglichkeit bietet die Beleuchtung mit Lichtleitern aus mehreren Richtungen.

In bekannten Vorrichtungen werden jeweils verschiedene Bilder mit der Fernsehkamera bei verschiedenen Beleuchtungsrichtungen aufgenommen. Die Beurteilung des Prüfobjektes erfolgt durch die Auswertung der Schattenwürfe, die durch die Bauteile auf einer Leiterplatte verursacht werden. Bei der Auswertung mehrerer Bilder, bei denen das Prüfobjekt aus verschiedenen Richtungen beleuchtet wurde, kann man auf Größe und Form der Bauteile aus dem Schattenwurf schließen.

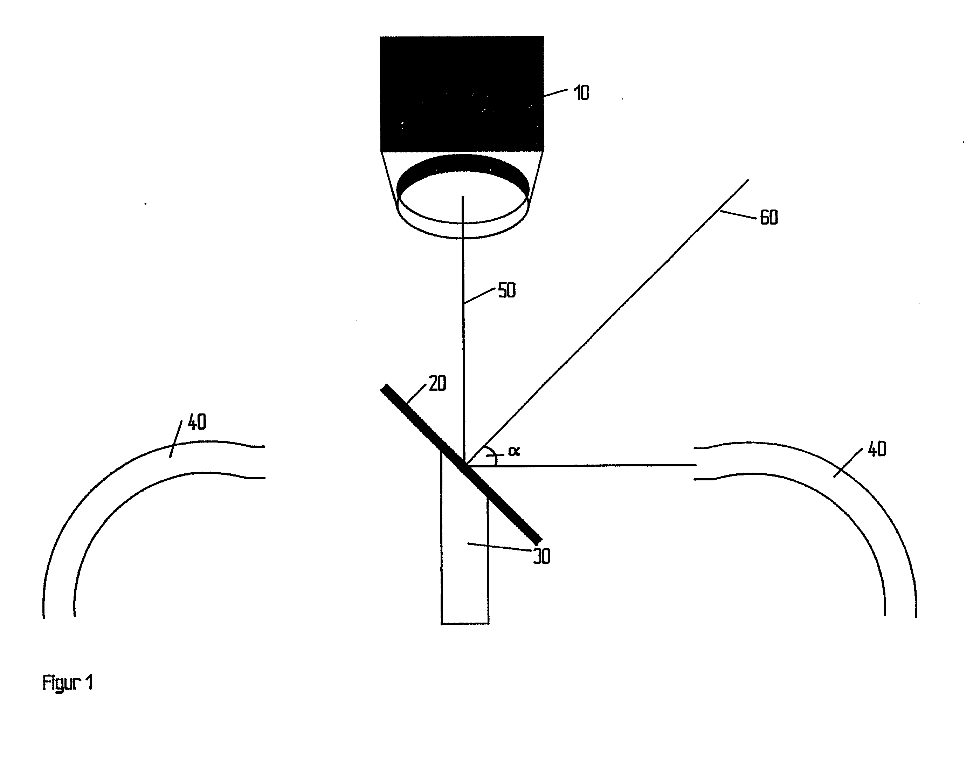

Die Beleuchtung aus den verschiedenen Richtungen wird durch eine Vorrichtung nach Figur 1 ermöglicht. Diese Figur zeigt eine Lichtquelle 10, die Licht entlang der Strahlungsachse 50 auf einen Spiegel 20 strahlt. Der Spiegel 20 ist auf eine Welle 30 montiert, wobei die Wellenachse mit der Strahlungsachse 50 zusammenfällt und die Spiegelachse 60 einen Winkel mit der Strahlungsachse 50 derart bildet, daß der Beleuchtungsstrahl der Lichtquelle 10 auf ein Ende des Lichtleiters 40 umgelenkt wird, wobei der Lichtleiter 40 zur Beleuchtung der Prüffläche dient. Die Welle 30 ist drehbar, z.B. durch einen Motor angetrieben, gelagert, so daß rings um die Welle 30 angeordnete Lichtleiter zyklisch mit dem Licht der Strahlungsquelle versorgt werden.

Bei dieser Art der Beleuchtung geht ein nicht unerheblicher Teil der erzeugten Lichtintensität durch Streuung verloren. Außerdem ist die Drehgeschwindigkeit der Welle begrenzt, so daß die Aufnahme der Bilder länger dauert, als dies seitens der Bildverarbeitungseinheit notwendig ist, und die Beleuchtungsreihenfolge ist weitgehend von der Drehrichtung der Welle festgelegt, da ein oftmaliges Wechseln der Drehrichtung nicht nur die Abnutzung der mechanischen Einrichtungen zur Folge hat, sondern auch eine weitere Einbuße an Geschwindigkeit bei den Beleuchtungswechseln von einen Lichtleiter auf einen anderen.

Aus der Deutschen Offenlegungsschrift DE-OS 38 22 311 ist eine Anordnung zur stromlosen Fernbedienung eines Schalters in einer elektrischen Schaltung bekannt. Bei dieser Anordnung wird in einem Lichtleiter Licht einer permanent leuchtenden Lichtquelle eingespeist. Im Lichtleiter ist ein Fernschalter angeordnet, der diesen Lichtleiter lichtdurchlässig oder lichtundurchlässig schalten kann. Der fernzubedienende Schalter ist als lichtempfindlicher Schalter ausgeführt, der einen Schaltzustand in Abhängigkeit vom Lichteinfall einnimmt. So ist beispielsweise bei Lichteinfall der Schaltzustand "Ein", während er "Aus" ist, wenn kein Licht einfällt, wobei das Licht durch den Lichtleiter an den lichtempfindlichen Schalter geleitet wird.

Aufgabe der Erfindung ist es nun, ausgehend vom bekannten Stand der Technik, eine Vorrichtung zur Leiterplattenprüfung, insbesondere eine Beleuchtungsvorrichtung für die Leiterplattenprüfung anzugeben, bei der eine verschleißarme und universell ansteuerbare Beleuchtung des Prüfobjektes aus verschiedenen Richtungen möglich ist.

Diese Aufgabe wird gelöst durch die Merkmale im kennzeichnenden Teil des Anspruchs 1. Vorteilhafte Ausgestaltungen der Erfindung ergeben sich aus den Unteransprüchen.

Gemäß der Erfindung werden die einzelnen Lichtleiter direkt mit der Lichtquelle bzw. mit derem Gehäuse verbunden, so daß eine freie Strecke, auf der das Licht streuen und Intensität verlieren kann, nicht überbrückt werden muß. In die einzelnen Lichtleiter werden Lichtventile eingefügt, die den Lichtleiter lichtdurchlässig oder lichtundurchlässig schalten können. Die Lichtventile werden durch Steuersignale, vorzugsweise durch elektrische Steuersignale, in den lichtdurchlässigen bzw. den lichtundurchlässigen Zustand gebracht, wobei die Steuersignale in einem Mikroprozessor, der die Ablaufsteuerung der Kontrolleinrichtung durchführt, erzeugt werden. Auf diese Weise kann die Reihenfolge, mit der das Prüfobjekt aus den verschiedenen Richtungen beleuchtet wird, frei gewählt werden. Weiterhin ist die Geschwindigkeit, mit der die Beleuchtungsrichtung gewechselt wird, nur von der Schnelligkeit der Lichtventile und der Geschwindigkeit der Bildverarbeitung bzw. der Auswertung abhängig. Die Lichtventile können als Schiebeblende ausgeführt sein, die in einer Stellung lichtdurchlässig sind, in der anderen lichtundurchlässig.

In einer vorteilhaften Ausgestaltung der Erfindung werden Flüssigkristallelemente als Lichtventile in die Lichtleiter eingefügt. Bei diesen Flüssigkristallelementen werden durch ein elektrisches Feld die Flüssigkristalle derart ausgerichtet, daß infolge Drehung der Polarisationsrichtung ein lichtdurchlässiges oder ein lichtundurchlässiges Lichtventil entsteht.

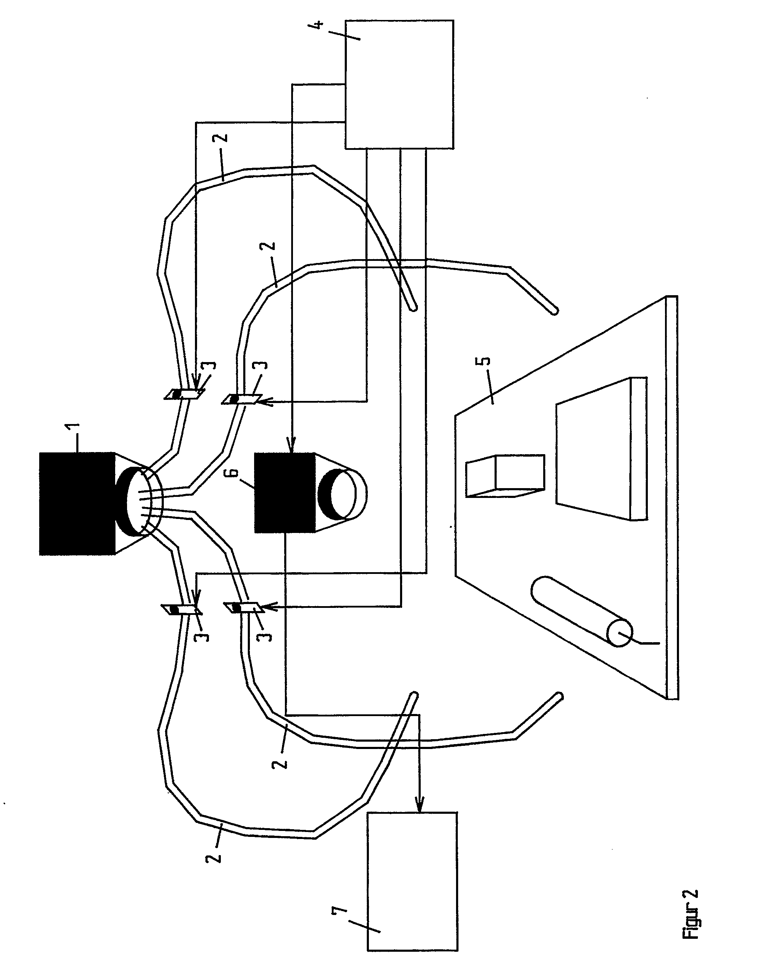

Im folgenden wird die Erfindung anhand der Figur 2 erläutert:

Bei der erfindungsgemäßen Anordnung wird das Licht einer Lichtquelle 1 direkt in die Lichtleiter 2 eingespeist. In Figur 2 sind vier Lichtleiter zur Beleuchtung des Prüfobjektes 5, das aus einer bestückten Leiterplatte besteht, aus vier Richtungen dargestellt, wobei die Lichtleiter so angeordnet sind, daß das Prüfobjekt jeweils von oben aus seitlicher Richtung beleuchtet wird.

Jeder Lichtleiter 2 enthält ein Lichtventil 3, mit dem der Lichtfluß im jeweiligen Lichtleiter unterbrochen werden kann. Die Ansteuerung der Lichtventile 3 erfolgt durch eine Steuereinheit 4, mit der auch eine Fernsehkamera 6 angesteuert wird.

Es wird jeweils ein Lichtleiter 2 lichtdurchlässig geschaltet, so daß die bestückte Leiterplatte 5 aus einer Richtung beleuchtet wird. Die auf der Leiterplatte aufgebrachten Bauelemente verursachen durch die seitliche Beleuchtung Schatten, die später ausgewertet werden. Wenn ein Lichtleiter 2 lichtdurchlässig geschaltet wurde, wird gleichzeitig ein Bild mit der Fernsehkamea 6 aufgenommen. Das aufgenommene Bildsignal wird der Auswerteeinheit 7 zugeführt. Anschließend wird der nächste Lichtleiter lichtdurchlässig geschaltet und ebenfalls ein Bild aufgenommen und der Auswerteeinheit 7 zugeführt. Auf diese Weise werden vier Bilder aufgenommen, wobei bei jedem Bild die Leiterplatte 5 aus einer anderen Richtung beleuchtet wurde, so daß im Speicher der Auswerteeinheit vier Bilder vorliegen, die unterschiedliche Schattenbereiche aufweisen. Durch die Auswertung dieser Schattenbereiche bezüglich Lage, Größe und Form, kann auf die Lage und Größe der sich auf der Leiterplatte befindlichen Bauelemente geschlossen werden. Durch Vergleich mit Referenzwerten, die aus einer fehlerfrei bestückten Leiterplatte gewonnen werden, können Bestückungsfehler bei der zu prüfenden Leiterplatte festgestellt werden.

Die erfindungsgemäße Vorrichtung bringt die Vorteile, daß durch die direkte Ankopplung der Lichtleiter an die Lichtquelle keine Lichtleistung verloren geht. Weiterhin können die Lichtleiter in beliebiger Reihenfolge lichtdurchlässig geschaltet werden, oder es können gleichzeitig mehrere Lichtleiter lichtdurchlässig geschaltet werden.

Durch die erfindungsgemäße Vorrichtung wird also der Prüfvorgang flexibler.

## Patentansprüche

1. Vorrichtung zur Beleuchtung von Prüfobjekten, insbesondere Leiterplatten und der auf den Leiterplatten aufgebrachten Bauteile in einem Leiterplattenprüfsystem, wobei zur Beleuchtung aus verschiedenen Richtungen mehrere Lichtleiter angeordnet sind, in die Licht eingespeist wird, **dadurch gekennzeichnet,** daß

   - das Licht einer Lichtquelle gleichzeitig in alle zur Beleuchtung vorhandenen Lichtleiter permanent eingespeist wird,
   - die einzelnen Lichtleiter mit elektrisch ansteuerbaren Lichtventile versehen sind, die den Lichtleiter in lichtleitenden und lichtundurchlässigen Zustand schalten,
   - die Lichtventile von einer Steuereinheit angesteuert werden.

2. Vorrichtung nach Anspruch 1, **dadurch gekennzeichnet,** daß die Lichtventile aus Flüssigkristallelementen bestehen.

Figur 1

EP 0 461 395 A2

Figur 2